# EUROPEAN PATENT APPLICATION

(11) **EP 0 691 357 A1**
(43) Date of publication of application: **10.01.1996**
(21) Application number: 95304191.0
(22) Date of filing: 16.06.1995
(51) Int. Cl.: C08G 18/67

(54) **Liquid polyurethane (meth)acrylate photopolymer useful for flexographic printing plate**

(30) Priority: 17.06.1994 US 261642
(71) Applicant: Polyfibron Technologies, Inc., Atlanta, Georgia 30336-2293 (US)
(72) Inventor: Ebner, Cynthia Louise, New Market, Maryland 21774 (US)
(74) Representative: Jones, Helen Marjorie Meredith

(57) **Abstract**

A liquid photopolymer useful in preparing water developable, tack-free, solid substrate is prepared by using an amine-modified polyether based polyurethane (meth)acrylate polymer suitably formulated with a photoinitiator system comprising benzophenone. The method for obtaining the tack-free surface is further obtained by post curing treatment with germicidal radiation exposure.

## Description

### Field of Invention

This invention relates to radiation curable polymers and formulations or compositions containing such polymers, as well as photosensitive articles having solid surfaces or layers prepared from such polymers or formulations. The invention also relates to a process for making and using the polymers.

### Background Of The Invention

Photocurable polymers and compositions are known in the art of forming printing plates and other photosensitive or radiation curable articles. In the field of radiation curable flexographic printing plates, the plates typically comprise a support and a photosensitive surface or layer from a photocurable composition.

Photoresin relief plates are generally prepared by imagewise exposing a photosensitive resin layer provided on a support to actinic rays through an image-bearing transparency, such as a negative film; washing out the unexposed (uncured) areas of the photosensitive resin layer with a developer (such as an organic solvent, an aqueous salt or alkaline solution, an aqueous solution of a surfactant, or water); and effecting post-exposure treatment to ensure completion of cross-linking, followed by drying. See e.g., Australian Patent AU-B-62273/90, incorporated by reference herein.

Additional background information can be obtained from U.S. Patent Application Serial Nos. 07/003,167, and 08/198,460, the disclosures for which are incorporated by reference herewith.

Polymeric materials and articles sometimes have a problem of surface tackiness that may exist after curing. This tackiness is a particular problem for photopolymer printing plates since the surface tack will increase dust and lint pick-up, web pull and paper peeling, and cause stacking and storage difficulties, to name but a few of the problems.

A variety of methods are known involving chemical or physical treatment to decrease surface tack of polymeric and photocurable polymeric materials. For photocurable materials in particular, these include methods in which relief images are treated with an oxidant, reducing agent or the like; methods in which a coating material is applied onto the surface of the relief image; and methods in which post exposure of the relief images to actinic radiation is conducted in an inert gas or while dipping the relief images in a liquid so that oxygen does not inhibit the photocuring. See e.g. U.S. Patent No. 4,806,506. It is also known to add fatty acids or waxy materials which migrate to the surface of the polymer upon curing to decrease the surface tack.

U.S. Patent No. 4,400,459 teaches a process for detackifying photosensitive elastomeric flexographic printing plates, wherein the developed, dried surface is, in either order, (1) post-exposed to actinic radiation, and (2) treated with a solution of an alkali monopersulfate and a bromide salt.

U.S. Patent No. 4,202,696 teaches a method of removing surface tack from photopolymer printing plates by impregnating the surface layer with an organic carbonyl compound capable of abstracting a hydrogen atom and then irradiating the plate with actinic radiation having wavelengths of 200-300 nm to excite the organic carbonyl compound.

U.S. Patent 4,716,094 teaches that a compound, such as a saturated or unsaturated carboxylic acid, amide, or alcohol, is incorporated into the photosensitive resin composition.

Published EP Application No. 0 017 927 teaches a process for detackification of photosensitive elastomeric printing plates, which have been developed or "washed out" with an organic solvent or mixture of solvents, e.g., perchloroethylene/n-butanol or trichloroethylene, by exposing to light having a wavelength not longer than 300 nm, e.g. with "germicidal"lamps.

U.S. Patent No. 4,806,506 teaches a process for detackifying an imagewise exposed and solvent-developed flexographic relief printing plate. The process comprises the steps of drying the plate after development, applying an aprotic solvent to the surface of the plate, and subsequently exposing the printing surface to radiation with wavelengths in the range of 200-300 nm. The process also involves exposing the printing surface simultaneous, or prior to using the 200-300 nm wavelength.

U.S. Patent Application 07/003,167 discloses a method of decreasing the tacky surface of polymeric materials by using a urethane-based, preferably a polyether urethane prepolymer as a binder in a two component photosensitive system. The first photosensitive component comprises a benzoin alkyl ether carbonyl compound. The second photosensitive component comprises an amine compound and a benzophenone photoinitiator operative to abstract hydrogen from the amine compound, and thereby decreasing surface tack of a cured article formed from the polymeric binder, upon exposure to radiation having wavelengths in the range of 200-300 nm. However, in using this method the amine and the benzophenone must be compatible and not separate into discrete phases. Moreover, this method requires the use of environmentally sensitive monomers.

Photopolymer relief printing plates are often manufactured in dimensions of approximately 30 x 40 inches or larger, a size which makes handling during processing and treatment difficult. It is believed that post-development surface spraying, coating, or dipping does not guarantee that the active surface ingredient is present in an effective or uniform concentration at the surface of the cured printing plate or article to be treated.

The concept of reducing surface tack; or of obtaining a "tack-free" surface, as used in this invention, refers more than just to the state in which the stickiness of the cured polymeric article is decreased or avoided. In photocurable relief printing plates, a plate which has been developed, washed to remove uncured polymer, post-exposed under water, and dried, such as by using an oven, may be considered initially to have little or no tack on the surface. However, it has been found that after wiping alcohol onto the dried surface, in emulation of the effect of contact with alcohol-containing inks, the surface can consequently become tacky to the touch. Therefore, the concept of surface detackification, as contemplated in the present invention, involves a permanent post-development state of decreased surface stickiness.

Accordingly, the present invention relates to an improved method and composition for preparing inherently tack free polymeric materials and, in particular, photocurable relief printing plates, without using environmentally sensitive solvents and/or monomers and without requiring the use of binders or other detackifying additives.

### Summary of The Invention

Therefore, it is the object of this invention to provide a liquid composition suitable for use in flexographic printing applications that is inherently tack free, i.e. does not require the use of binders or other additives to correct a tackiness problem and has a low Shore A value when cured. Another object of the present invention is to obtain a photocurable liquid composition that is water dispersable and avoids the use of environmentally sensitive solvents. Furthermore, it is an object of this invention to prepare a composition suitable for use in flexographic printing applications that has no problems with additives or other agents blooming to the surface. It is another object of the present invention to prepare a printing plate surface that is more resistant to alcohol based inks.

Yet another object of the present invention is to provide a method for making a photocurable-polymeric article, such as a relief flexographic printing plate, that is tack free and does not require any post-development treatment.

The present invention is a liquid photopolymer, which has a low Shore A upon ultra-violet curing and is tack free when cured. The photopolymer of the present invention is an amine modified polyether based polyurethane (meth)acrylate, wherein the expression (meth) includes either the acrylate or methacrylate. An exemplary composition of the invention comprises a photocurable polymer comprising J-Y-R¹-J, wherein the J's, Y, and R¹ are as follows:
J is CH₂=C(R)-C(:O)-O-R³-O-;
Y comprises B and R⁴;
B is -[X[NHC(:O)]₂-O-(A-O)_{b}]ₓ-;
(A-O) is -CH₂CH₂-O-, -CH₂CH(CH₃)-O-,
-CH₂CH₂CH₂CH₂-O-,
-CH₂CH₂CH(CH₃)-O-, or -CH₂CH(CH₃)CH₂-O- and mixtures thereof;
R⁴ is -[X[NHC(:O)]₂-O-R⁵-R⁶-R⁷-O]_{y}
R¹ is -X[NHC(:O)]₂-;
R is H or CH₃;
R³ is 1 to 7 carbon straight chain or branched alkylene or -(A-O)_{b}-;
R⁵ and R⁷ are the same or different alkylene groups with 1-8 carbons; or R⁵ can be
-(CH₂CH₂O)_{d}CH₂CH₂- provided R⁷ is
-(CH₂CH₂O)ₑCH₂CH₂-, where d and e are each 0 to 9 and d+e=3 to 15;
R⁶ is -N(R⁸) or -N N- or -N(Ph), where Ph is phenyl;
R⁸ is H or alkyl group of 1 to 8 carbons; and
X groups are the same or different and are selected from divalent aliphatic, cycloaliphatic and aromatic moieties containing 2 to 100 carbons.

Y can alternatively be considered as being made up of groups -B- and -R⁴- of which there may be one or more than one of each which may be randomly arranged or arranged in blocks of each type. Y can be represented as ⁅BR⁴⁆_{z}.
B can alternatively be represented 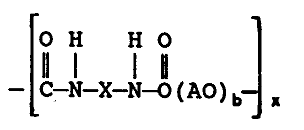
R⁴ can alternatively be represented

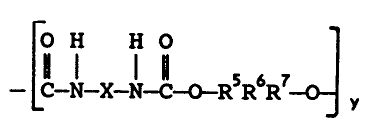

The x units of B and the y units of R⁴ can be arranged as blocks or randomly in the moiety Y.
R¹ can alternatively be represented

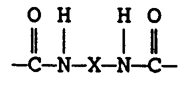

The polymer above most preferably is as described where B comprises R¹⁰ and R¹¹ wherein
R¹⁰ is -[X[NHC(:O)]₂-O-(C₃H₆O)ₙ]ₓ- and
R¹¹ is -[X[NHC(:O)]₂-O-(C₂H₄O)ₘ-(C₃H₆O)ₚ-(C₂H₄O)ₘ]_{y}-.

Most preferably the polymer above is as described wherein
R is CH₃-;
R³ is -(CH₂CH(CH₃)O)_{q}-;
R⁵ and R⁷ are ethylene;
R⁶ is N(R⁸);
R⁸ is CH₃; and
X is toluene.

A method of preparing the photocurable polymer described above comprises the following steps:
(I) reacting, in the mole ratios stated, polyether diol, having a molecular weight of from about 650 to 8000 (preferably up to 7000) (about 1 mole) with a diisocyanate, about 1.2 to about 4 moles, thereby end-capping the diols with isocyanate;
(II) adding a dialkanolamine in a mole ratio of from about 0.01 to about 5 to the reaction mixture of (I), thereby incorporating an amine into the backbone of the polymer; and
(III) adding to the reaction mixture of (II), hydroxyalkyl(meth)acrylate from about 0.2 to about 1.0 moles and continuing the reaction to react the terminal isocyanate groups of (II) with the hydroxy group of the hydroxyalkyl(meth)acrylate, thereby providing a photocurable polymer.

Preferably the sum of the mole contents of polyether diol and dialkanolamine to diisocyanate is less than the mole contents of diisocyanate, for instance such that substantially all the prepolymer product of step (II) is diisocyanate-terminated. Preferably the sum of the equivalents of isocyanate groups is less than the sum of equivalents of hydroxyl groups in the diol, the dialkanolamine and the hydroxyalkyl (meth)acrylate, so that substantially every molecule has two acrylate terminal groups.

The present invention further includes a method of preparing a flexographic printing plate surface substrate, the method comprising the steps of:
a) blending the photocurable polymer described above with about 0 weight % to about 70 weight % of a photoactive (meth)acrylate monomer or oligomer;
b) blending the blend from step (a) with a photoinitiator system that comprises about 0.01 weight % to about 10 weight % of benzophenone;
c) casting the blend from step (b) onto a cover sheet (preferably polypropylene) using a containment dam and laminating a backing sheet (preferably, polyester) over the composition creating an article;
d) photocuring the casted liquid blend (b) through the backing sheet to create a plate floor and then curing through the cover sheet through a negative to create an image with actinic radiation;
e) developing the image by washing away the uncured polymer that was unexposed in step (d) with aqueous surfactant solution;
f) optionally, placing the article into water and subjecting the article to post-development exposure to actinic radiation to ensure through cure;
g) drying the developed article; and
h) treating the cured surface substrate by exposing to actinic, for instance UV, preferably germicidal radiation.

Alternatively (f) and (h) can be completed simultaneously, either in air and water, with the same results.

### Detailed Description Of The Invention

The photopolymer of the present invention is achieved by the following main reactions.
1. P + Cy → (Cy-P)ₓ-Cy (I);
2. N + Cy → (Cy-N)_{y}-Cy (II);
3. I + N + II → [(Cy-P)ₓ-(Cy-N)_{y}]_{z}-Cy (Prepolymer III, or III);
   *(Note: Reactions 2. and 3. go forward together.)*
4. III + A → A-[(Cy-P)ₓ-(Cy-N)_{y}]_{z}-Cy-A (Photopolymer IV, or IV,)

where P is a polyether diol or its moieties, Cy is a diisocyanate or its moiety, N is an alkyldialkanolamine or its moiety, and A is selected from the group consisting of polypropylene glycol monomethacrylate, hydroxyalkyl(meth)acrylate, their moieties and mixtures thereof. In these reactions hydroxyl containing compounds are linked to diisocyanate containing compounds via urethane linkages, -NH-C(:O)-O-, to form the respective moieties. x, y, and z may differ from molecule to molecule, but are such that x and y are each at least 1 and the over-all molecular weight of Prepolymer III, is in the range of about 1,000-40,000 (preferably about 2,000-20,000), and that of Photopolymer IV is in the range of about 1,000-50,000 (preferably about 3,000-30,000). Segments of I and II may be positioned randomly in the chain.

The aforesaid four reactions may be restated explicitly. In this restatement the mole ratio of P:Cy:N:A may be 1:1.2-4:0.01-5.0:0.2-1, preferably 1:1.4-2.6:0.2-1.2:0.4-0.8.

Depending on the molecular weight of the polyether polyols, it is preferable to select the molar ratio of the reactants P (for polyols), Cy (for diisocyanate), N (for alkyldialkanolamine) and A for hydroxyalkyl(meth)acrylate such that: (weight percent as cited below is based on the total weight of the final photopolymer):
(a) the total polyol content is preferably between about 60 and about 90 weight percent in order for the final photopolymer to have good flexibility or elastomeric properties and
(b) the alkyldialkanolamine content is preferably about 0.1 to about 10 weight percent in order to maintain good water developability and
(c) the hydroxyalkyl(meth)acrylate content is preferably about 0.5 to about 8.0 weight percent so that good photocurability and hence good resistance to ink swell can be achieved.

1. Reaction of polyether diol (P) with the aforestated stoichiometric excess of diisocyanate (Cy):

   HO-(-A-0-)_{b}H + excess OCNXNCO → OCN-D-X-NCO (I)

   where A is

   -CH₂CH₂-, -CH₂CH₂-CH₂-, -CH₂CH(CH₃)-,

   -CH₂CH₂CH₂CH₂-, -CH₂CH₂CH(CH₃)-,

   -CH₂CH(CH₃)CH₂- or any di-functional

   diol and mixtures thereof;
   D represents one or more segments of

   [-X-NH-C(:O)O(-A-O-)_{b}C(:O)NH-]

   b is determined by the molecular weight of the polyether diol and is discussed in the description of polyether diol, below.
   X is a divalent aromatic, aliphatic, or cycloaliphatic group containing 2-100 carbon atoms preferably 5-15 carbon atoms.
   These end-capping reactions are well-known. As indicated, the terminal isocyanates on initially formed end-capped diols may react with other hydroxyl groups on other polyethers, thereby increasing over-all molecular weight of the resulting polyurethane. This reaction is suitably carried out at conventional temperatures, e.g., within the range of about 25°-80°C
   Chain extension of prepolymer product (I) with alkyldialkanolamine (HO-R⁵-R⁶-R⁷-OH). In this operation, Reactions 2 and 3 go forward together, the product II of Reaction 2 serving as an intermediate in Reaction 3:
2.

   OCN-X-NCO + HO-R⁵-R⁶-R⁷-OH → OCN-F-X-NCO (II)

   where F represents one or more segments of

   [-X-NH-C(:O)-O-R⁵-R⁶-R⁷-O-C(:O)NH-]

   R⁵ and R⁷ are the same or different alkylene groups with 1-8 carbons; or R⁵ can be
   -(CH₂CH₂O)_{d}CH₂CH₂- provided R⁷ is
   -(CH₂CH₂O)ₑCH₂CH₂-, where d and e are each 0 to 9 and d+e=3 to 15;
   R⁶ is -N(R⁸)-, 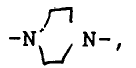 or -N(Ph)-, where Ph is phenyl; and
   R⁸ is an alkyl group with 1-8 carbons, or H.
3.

   I + HO-R⁵-R⁶-R⁷-OH + II → OCN-E-X-NCO (Prepolymer III),

   where E comprises one or more segments of D and one or more segments of F; which is to say, E comprises D and F.

Reactions 2 and 3 are carried out in the same reaction mixture substantially simultaneously, at a temperature in the range of about 25°C to about 60°C, until all of the hydroxyl groups have reacted as determined by titration of the remaining isocyanate. As indicated, individual polymer chains in III may be expected to vary in the number of polyether diol, diisocyanate, and alkyldialkanolamine moieties. The reactant proportions are controlled within the ranges stated above so that all or substantially all polymer chains will terminate in isocyanate. This condition is essential for the fourth (and final) step. A small amount of residual free diisocyanate may be left after the formation of III.

In Reactions 2 and 3, note that the molar ratio, Cy/P+N), is always >1.

Within III a preferred structure results when
X is toluene (TDI)
R⁵ and R⁷ are ethylene;
R⁶ is -N(R⁸)-;
R⁸ is methyl;
the diols include a mixture of an ethylene oxide end capped polyoxypropylene diol and a polypropylene glycol diol where (A-O-)_{b} has a molecular weight of about 1000-3500.

Reaction 4. Reaction of chain-extended polymer (Prepolymer III) with either hydroxyalkyl(meth)acrylate, e.g. hydroxyethylmethacrylate (HEMA) or polypropylene glycol monomethacrylate (PPGMMA), their moieties or mixtures thereof to give Photopolymer IV:

III + HO-R³-O-C(:O)-C(R) = CH₂ → J-R¹⁰-R¹¹-R⁴-R¹-J (IV)

where R³ is 1 to 7 carbon alkylene or (A-O)_{b} and R is methyl or H,
and where the J's are identical and are

CH₂ = C(R)-C(:O)-O-R³-O-;

- R¹⁰ is: [X[NHC(:O)]₂-O-(C₃H₆O)ₙ]ₓ, wherein X is divalent aliphatic, cycloaliphatic, or an aromatic group containing 2 to 100 carbons, or a modified diisocyanate;
- R¹¹ is: [X[NHC(:O)]₂)-O(C₂H₄O)ₘ-(C₃H₆O)ₚ-(C₂H₄O)ₘ]_{y}, wherein X is divalent aliphatic, cycloaliphatic, or an aromatic group containing 2 to 100 carbons, or a modified diisocyanate;
- R⁴ is: [X[NHC(:O)]₂-O-R⁵-R⁶-R⁷-O]_{y}-; wherein X is divalent aliphatic, cycloaliphatic, or an aromatic group containing 2 to 100 carbons, or a modified diisocyanate;
- R¹ is: [X[NHC(:O)]₂], wherein X is divalent aliphatic, cycloaliphatic, or an aromatic group containing 2 to 100 carbons, or a modified diisocyanate; and
- R⁵ and R⁷: are the same or different alkylene groups with 1 to 8 carbons; or R⁵ can be

-(CH₂CH₂O)_{d}CH₂CH₂- provided R⁷ is
-(CH₂CH₂O)ₑCH₂CH₂-, where d and e are each 0 to 9 and d+e=3 to 15.

This Reaction 4 is suitably carried out at a temperature in the range of about 60°C to about 80°C and is conveniently carried out following chain extension Reactions 2 and 3, in the same vessel. As indicated, most of the molecules comprise multiple moieties of polyether diol, end-capping diisocyanate, and chain-extending dialkanolamine, with all or substantially all polymer molecules of IV being terminated with hydroxyalkyl(meth)acrylate, preferably polyproylene glycol monomethacrylate (PPGMMA).

The reactions described are carried out without a solvent.

The following is a further description of the reactants.

### The Diol

(a) Polyether Diol.

This product has the structure HO-(A-O)_{b}H where A is a divalent radical of ethylene, propylene, isopropylene, butylene, isobutylene; and b is such that the number average molecular weight of the group [A-O)_{b}, or of the polymer diol (which is substantially the same thing) is within the range of about 650 to about 7,000, preferably about 1,000-3,500. Polypropylene oxide glycol ie (C₃H₆O)ₙ, MW about 1,000-3,500, or polypropylene oxide end-capped with ethylene oxide, where the amount of ethylene oxide is about 1-50 weight percent of the total polymer, preferably about 10-30 weight percent, of the overall molecular weight, MW about 1,000 to 7,000 preferably 1,000-4,000, and mixtures of such glycols are especially preferred. In the instance where copolymers are used, the idealized structure for (A-O)_{b} would be
[-(CH₂CH₂O)ₘ-(CH₂CH(CH₃)-O)ₚ-(CH₂CH₂O)ᵣ]- where m + r and p are such that the ethylene oxide moiety represents about 1-50, preferably about 10-30, weight percent of the overall polyol molecular weight (and m+r+p=b, preferably m and r being substantially equal. Such copolymers include POLY G55-37 (MW 2952, containing about 30 weight percent of ethylene oxide), and POLY L 225-28 (MW 4000, containing about 20 weight percent ethylene oxide); both available from Olin Corp. The polyether diol reactants may be made by processes well known in the art by reacting an alkylene oxide or mixtures of alkylene oxides with a compound having at least one active hydrogen atom, such as water; monohydroxylic alcohols such as ethanol and propanol; and dihydroxylic alcohols such as ethylene glycol and monoethyl ether of glycerine. The poly(oxyalkylene) products of such reactions will have linear oxyalkylene or oxyethylene-higher oxyalkylene chains, and such chains will terminate with hydroxyl groups. Conventional potassium hydroxide catalysts or double metal cyanide catalysts can be used.

### The Diisocyanate

A wide variety of diisocyanates is available for end-capping the polyether diol. These diisocyanates can be aliphatic, cycloaliphatic, or aromatic, with the structure OCN-XNCO. The divalent radical X contains in general 2 to 100 carbon atoms and may optionally carry non-interfering substituents such as ether groups, ester groups, urethane groups, amido groups, urea groups, aryl groups, aliphatic groups, cycloaliphatic groups, or halogen atoms. Modified diisocyanates are also usable. Examples of suitable diisocyanates include 4,4'-methylene diphenyl diisocyanate (MDI), modified MDI, such as MDI reacted with a polyether polyol, available as Isonate 2181 from Dow chemical Co., and MDI prepolymers, 2,4-tolylene diisocyanate (toluene diisocyanate), 2,6-tolylene diisocyanate, mixtures of the two latter isomers, dimer of 2,4-tolylene diisocyanate, p-xylene diisocyanate, m-xylene diisocyanate, 1,5-naphthalene diisocyanate, 3,3'-dimethylbiphenyl-4,4'-diisocyanate, hexamethylene diisocyanate, trimethylhexamethylene diisocyanate, lysine diisocyanate, isophorone diisocyanate, 4,4'-methylenebis(cyclohexylisocyanate), methylcyclohexane-2,4 (or 2,6)-diisocyanate, 1,3-(isocyanatomethyl)cyclohexane, m-tetramethylxylene diisocyanate, p-tetramethylxylene diisocyanate, and mixtures thereof. The preferred diisocyanate is a blend of 2,4-tolylene diisocyanate and 2,6-tolylene diisocyanate.

Conventional urethane-forming catalysts may be used in the reactions with diisocyanates. These catalysts include, e.g., organo-tin compounds such as dibutyl tin dilaurate and stannous octoate, organo-mercury compounds, tertiary amines, and mixtures of these materials.

### Alkyldialkanolamine

This material has the structure HOR⁵R⁶R⁷OH, where the numbered R's are as above defined. In the group R⁶, preferably R⁸ is not H. Within this group, methyldiethanolamine (HOC₂H₄N(CH₃)C₂H₄OH), N,N'-bis(hydroxyethyl)- piperazine 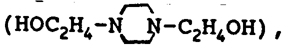
and N,N-Bis (2-hydroxypropyl)aniline (HO-CH(CH₃)CH₂-N(Ph)- CH₂CH(CH₃)OH), are preferred. (Ph is phenyl.)

### Hydroxyalkyl(meth)acrylate

This material has the structure HO-R³OC(:O)-C(R)=CH₂, where the R's are as above defined. Within this structure PPGMMA is preferred.

### Formulations with the Invention Photopolymer

The simplest formulation is the invention photopolymer plus an effective amount of photoinitiator. Such mixture can be casted as is. However, for many commercial uses it will be found preferable to formulate or extend the photopolymerizable composition with about 1% to about 75% by weight of reactive (i.e., photoactive) monomer or oligomer, and most preferably in the range of about 5% to about 50% by weight reactive monomer. Suitable reactive monomers or oligomers are those of the formula:

(CH₂=C(R)-C(:O)-O-)ₛ-R¹⁵

where R is H or methyl, R¹⁵ is an organic moiety having a valence of S, and S is an integer.

Such reactive (meth)acrylate diluents include, but are not limited to, trimethylolpropane triacrylate, hexanediol diacrylate, 1,3-butylene glycol diacrylate, diethylene glycol diacrylate, 1,6-hexanediol diacrylate, neopentyl glycol diacrylate, polyethylene glycol 200 diacrylate, tetraethylene glycol diacrylate, triethylene glycol diacrylate, pentaerythritol tetraacrylate, tripropylene glycol diacrylate, ethoxylated bisphenol-A diacrylate, propylene glycol mono/dimethacrylate, trimethylolpropane diacrylate, ditrimethylolpropane tetraacrylate, triacrylate of tris(hydroxyethyl) isocyanurate, dipentaerythritol hydroxypentaacrylate, pentaerythritol triacrylate, ethoxylated trimethylolpropane triacrylate, triethylene glycol dimethacrylate, ethylene glycol dimethacrylate, tetraethylene glycol dimethacrylate, polyethylene glycol-200 dimethacrylate, 1,6-hexanediol dimethacrylate, neopentyl glycol dimethacrylate, polyethylene glycol-600 dimethacrylate, 1,3-butylene glycol dimethacrylate, ethoxylated bisphenol-A dimethacrylate, trimethylolpropane trimethacrylate, diethylene glycol dimethacrylate, 1,4-butanediol diacrylate, diethylene glycol dimethacrylate, pentaerythritol tetramethacrylate, glycerine dimethacrylate, trimethylolpropane dimethacrylate, pentaerythritol trimethacrylate, pentaerythritol dimethacrylate, pentaerythritol diacrylate, urethanemethacrylate or acrylate oligomers and the like which can be added to the photopolymerizable composition to modify the cured product. Monoacrylates such as cyclohexyl acrylate, isobornyl acrylate, lauryl acrylate, polypropylene glycol monomethacrylate and tetrahydrofurfuryl acrylate and the corresponding methacrylates are also operable as reactive diluents, as well as methacrylate oligomers such as epoxy acrylates, urethane acrylates, and polyester or polyether acrylates.

### Photoinitiators

The formulations comprising the novel materials of this invention require a photoinitiator system, preferably containing benzophenone that comprises about 0.01 to about 10 percent of the total formulation.

A preferred photoinitiator system contains two parts. The primary photoinitiator causes the initial curing or cross-linking of the composition at wavelengths greater than 300nm. The secondary photoinitiator, which is fully incorporated into the polymeric composition, prior to initial curing, is thereafter exposed to radiation wavelengths in the range of 200-300 nm to initiate surface treatment. The two photoinitiators are characterized by an ultraviolet (UV) radiation absorption spectrum which are such that the two components can be selectively photoactivated by using different UV radiation wavelengths. The primary photoinitiator is preferably a carbonyl compound operative to cure the polymer by radical polymerization upon exposure to radiation having wavelengths of at least 300 nm or greater. The secondary photoinitiator is benzophenone or a benzophenone derivative, which upon exposure to radiation of wavelengths in the range of 200-300 nm (i.e., "germicidal radiation") decreases the surface tack of the cured article.

Primary photoinitiators for the photopolymerizable composition may be selected from known carbonyl compounds such as, the benzoin alkyl ethers, i.e., benzoin methyl ether, benzoin ethyl ether, benzoin isopropyl ether and benzoin isobutyl ether, the dialkoxyacetophenones exemplified by 2,2-dimethoxy-2-phenylacetophenone, i.e., Irgacure®651 (Ciba-Geigy), acetophenone, o-methoxybenzophenone, acetonaphthalene -quinone, methyl ethyl ketone, valerophenone, hexanophenone, alpha-phenyl-butyrophenone, p-morpholinopropiophenone, dibenzosuberone, 4-morpholinobenzophenone, 4'-morpholinodeoxybenzoin, p-diacetylbenzene, 4-aminobenzophenone, 4'-methoxyacetophenone, benzaldehyde, alpha-tetralone, 9-acetylphenanthrene, 2-acetylphenanthrene, 10-thioxanthenone, 3-acetylphenanthrene, 3-acetylindone, 9-fluorenone, 1-indanone, 1,3,5-triacetylbenzene, thioxanthen-9-one, xanthene-9-one, 7-H-benz[de]-anthracen-7-one, 1-naphthaldehyde, 4,4'-bis(dimethylamino)-benzophenone, fluorene-9-one, 1'-acetonaphthone, 2'-acetonaphthone, 2,3-butedione, acetonaphthene, benz[a]anthracene 7.12 diene, etc. Phosphines such as triphenylphosphine and tri-o-tolylphosphine are also operable herein as photoinitiators.

The secondary photoinitiators preferably comprise a carbonyl compound operative to abstract hydrogen when exposed to radiation having wavelengths in the range of 200-300nm. A preferred secondary photoinitiator is a benzophenone, having the formula O=C(R)₂ wherein R is a substituted or an unsubstituted phenyl ring. The use of benzophenone, wherein the phenyl rings are unsubstituted is preferred.

Although benzophenone and benzophenone derivatives are known for use as primary photoinitiators, the present inventors believe that it has not been previously known or suggested to use benzophenone in combination with the amine modified polyurethane (meth)acrylate polymer described herein, as a secondary photoinitiator for post-development surface detackification, as taught by the present invention.

The photoinitiators can be from about 0.01% to about 10.0% by weight of the polymer, preferably of about 1.0% to about 2.5% by weight of the polymer. In a preferred embodiment, the primary photoinitiator is 2,2-dimethoxy-2-phenylacetophenone and the secondary photoinitiator is benzophenone. Although it is not desirable, it is possible to use a photoinitiator system that is 100% benzophenone.

### Other Additives

The compositions may also contain other additives, which are known in the art for use in photocurable compositions, e.g., antioxidants, antiozonants and UV radiation absorbers. To inhibit premature crosslinking during storage of the polymer containing compositions of this invention, thermal polymerization inhibitors and stabilizers are added. Such stabilizers are well known in the art, and include, but are not limited to, hydroquinone monobenzyl ether, methyl hydroquinone, amyl quinone, amyloxyhydroquinone, n-butylphenol, phenol, hydroquinone monopropyl ether, phenothiazine, phosphites, nitrobenzene and phenolic-thio compounds, and mixtures thereof. Such additives are used in an amount within the range of from about 0.01% to about 4% by weight of the polymer. These stabilizers are effective in preventing crosslinking of the polymer composition during preparation, processing and storage.

UV light absorbers, or UV light stabilizers, can be used to adjust the photospeed and, therefore, exposure latitude of the polymer material. Numerous materials will be apparent to those skilled in the art. The most important light stabilizer classes are: 2-hydroxy-benzophenones, 2-hydroxyphenyl benzotriazoles, hindered amines and organic nickel compounds. In addition, salicylates, cinnamate derivatives, resorcinol monobenzoates, oxanilides, and p-hydroxy benzoates are used as well. These additives are used in the range of about 0.01% to about 4% by weight of the polymer.

The compositions may also contain dye and/or pigment coloring agents. The colorants present in the photopolymer composition must not interfere with the imagewise exposure and should not absorb actinic radiation in the region of the spectrum that the initiators, present in the composition are activatable.

The colorant may be chosen from among the numerous commercially available pigments and dyes. The coloring agent may be used in a solvent soluble form, or in the form of a dispersion. Where a particulate material is used, the particle size should be less than 5000 Angstroms. More preferably, the particles will be in the 200-3000 Angstrom range.

Although numerous pigments and dyes useful in the practice of the present invention will be apparent to those skilled in the art, a small number of such materials are listed here.

Suitable pigments include the Microlith® series available from Ciba-Geigy. Especially preferred are the A3R-K and 4G-K materials. Suitable dyes include for example, Baso Blue 645 (C.I. Solvent Blue 4), Baso Blue 688 (C.I. Solvent Blue 81), Luxol Fast Blue MBSN (C.I. Solvent Blue 38), Neopen Blue 808 (C.I. Solvent Blue 70), Orasol™ Blue 2GLN (C.I. Solvent Blue 48), Savínyl® Blue GLS (C.I. Solvent Blue 44), Savinyl Blue RLS (C.I. Solvent Blue 45), Thermoplast Blue 684 (C.I. Solvent Violet 13) and Victoria Blue BO (C.I. Solvent Blue 7). Blue and violet are used in current applications but the color of the dye is not critical. Other colors could offer advantages, including for example, resistance to fading.

Formulations using the photopolymers of this invention include the following in weight percent:
(1) Photopolymer, about 40-99, preferably about 60-90;
(2) A mono-, di-, or multi-acrylate diluent, which can be a monomer or oligomer, about 0-60, preferably about 10-40;
(3) Photoinitiator, about 0.1-10, preferably about 0.5-2.5; and
(4) stabilizers, UV absorbers and colorants, 0.1 to 10, preferably about 1-4, total.

### Preparation of Plate

A relief printing plate is produced from the photosensitive resin composition by the following process: a photographic negative is placed on the lower glass plate of a commercial exposure unit, and covered with a 20 micron polypropylene protective film which is subsequently vacuumed down to remove any wrinkles or air pockets. The resin is applied to the cover film to a depth of 0.25'' (0.64 of cm) with the aid of a containment dam, and to the composition is laminated a polyester backing sheet. The composition is first given a back exposure through the top polyester backing using actinic lamps of a wavelength of 300-400 nm to create the plate floor and subsequently exposed imagewise through the negative using actinic lamps. The plate is washed with an aqueous detergent solution for 20 minutes to remove any residual uncured polymer.

The plate is rinsed and put in a drying oven at approximately 40°C for 30 minutes at which time it is removed and allowed to cool. The plate is then exposed to germicidal radiation (<300 nm) for 10 minutes in air to effect the tack free surface.

The following examples illustrate the invention, but are not meant to limit the invention.

### Example 1

To a 1L resin kettle were charged 1.71g triphenyl phosphite, 0.20g butylated hydroxy toluene, 139.2g of polypropylene glycol diol (PPG 3025, Arco Chemical Co.) having a number average molecular weight of about 3,000 and 108.8g of an ethylene oxide-propylene oxide block polyether diol (Poly G55-37, Olin Chemicals Co.) having a number average molecular weight of about 3,000 and about 30% by weight of ethylene oxide terminal units. The two polyols were reacted with 20g of a mixture of 2,4-tolylene diisocyanate/2,6-tolylene diisocyanate (TDI 80/20 by weight) in the presence of 3 drops dibutyl tin dilaurate at 80°C for 2-3 hours.

2.8g of butylated hydroxy toluene (BHT) stabilizer was added. The resulting isocyanate terminated polyurethane was chain extended with 2.11g of methyldiethanolamine (MDEA) at 60°C for 1-2 hours. The polymer was further reacted with 19.77g polypropyleneglycol monomethacrylate (PPGMMA) which has a number average molecular weight of 350-380, in the presence of 2 drops dibutyl tin dilaurate, at 70°C until all of the isocyanate was consumed as determined by IR spectroscopy by the disappearance of the peak at 2600 cm⁻¹. The PPGMMA is present in an excess.

To 40g of the polymer was added, 5.72g of polypropylene glycol monomethacrylate (PPGMMA), 0.93g of neopentyl glycol dimethacrylate (NPGDMA) and 0.47g 2,2-dimethoxy-2-phenyl-acetophenone (Irgacure 651) as a curing agent, to produce a photosensitive resin composition. A 20 mil film of the resin was prepared for physical testing by exposure on an Amergraph EU1218 exposure unit. See physical property data in Table 1.

### Example 2

125.3g PPG 3025, 95.84g Poly G55-37, 20g TDI, 1.71g triphenyl phosphite, and 0.2g BHT were reacted as in Example 1. 2.61g additional BHT was added and chain extension was carried out with 3.16g of MDEA followed by termination with 19.77g PPGMMA, as in Example 1.

The polymer was formulated and tested as in Example 1. See data in Table 1.

### Example 3

112.0g of PPG 3025, 82.1g Poly G55-37, 20g TDI, 1.71g triphenyl phosphite and 0.2 BHT were reacted at 60°C as in Example 1. 2.4g of additional BHT was added and chain extension was carried out with 4.21g MDEA. An exotherm of 8°C was noted. Further reaction of the isocyanate-terminated polyurethane with 19.8g PPGMMA was carried out as in Example 1.

The polymer was formulated and tested as in Example 1. See data in Table 1.

### Example 4

84.01g of PPG 3025, 54.8g Poly G55-37, 20g TDI, 1.71g triphenyl phosphite and 0.20g BHT were reacted at 60°C as in Example 1. 1.8g BHT and 6.32g MDEA were added in the chain extension step, followed by 19.8g PPGMMA to terminate the polymer as in Example 1.

The polymer was formulated and tested as in Example 1. See data in Table 1.

### Example 5

356.2g of Poly G55-37 and 50g TDI were charged to a 1L resin kettle and reacted at 60°C for 4 hours. 4.35g BHT, 130.5g Lauryl methacrylate used as a diluent, 13.7g MDEA, and 2 drops of dibutyl tin dilaurate were added and reacted at 50°C for 3-4 hours. At this point, 14.95g hydroxyethyl methacrylate (HEMA) were added and the reaction mixture stirred overnight at room temperature. By IR spectroscopy the NCO had disappeared and the reaction was complete.

The polymer was formulated and tested as in Example 1. See data in Table 1. This polymer had faster crack propagation than Examples 1-4.

### Comparative Example 1

164.5g of PPG 3025, 129.4g Poly G55-37, 20g TDI, 1.71g triphenyl phosphite and 0.20g BHT were charged into a 1L resin kettle and reacted at 80°C in the presence of 3 drops dibutyl tin dilaurate for 4 hours. The reaction mixture was cooled to 60°C and 23.37g of PPGMMA and 2 drops of dibutyl tin dilaurate were added. After 3 hours, the reaction was deemed complete by IR spectroscopy showing the complete disappearance of the NCO peak at 2600 cm⁻¹.

The polymer was formulated and tested as in Example 1. See physical data in Table 1.

### Tack Determination Test Method

To compare the level of tack resulting from different formulations and different post exposure conditions, the following test was carried out using cured printing plates.

The plates were prepared by casting a 0.25'' (6.35mm) layer of resin onto a polypropylene protective film, with the aid of a containment dam. A polyester backing sheet was laminated to the composition. The composition was given a back exposure through the polyester to create the floor, followed by face exposure through the polypropylene cover. The polypropylene cover was removed and the sample washed with an aqueous detergent solution for 20 min. to remove any uncured polymer.

Typically, the plate was either post exposed by giving 10 min. additional actinic radiation in air, or 10 min. of germicidal radiation in air. The post exposure conditions were varied to measure effect on tack.

The test to determine the level of tack on the plate was set up as follows. The tack was determined by pressing a clean piece of polyethylene terphthalate film onto the sample area and determining the amount of resistance to removing the film. The plate was wiped 20 times with 30% (by weight) isopropanol (IPA) in water, allowed to stand 15 seconds, and then blotted dry. The tack was again determined by pressing a clean piece of polyethylene terphthalate film onto the sample area and determining the amount of resistance to removing the film. This measurement was determined at 1 minute, 1 hour and 24 hours after wiping the sample with alcohol. If the sample remained tack-free, the test was repeated with 100% isopropanol.

The resins prepared in the Examples were formulated and tested as indicated in Table 2.

In Summary, tack tests showed that those plates which contained benzophenone in the photoinitiator package and amine in the polymer backbone and when given germicidal radiation, remained tack-free after the IPA wipe test. Those examples without benzophenone were tacky after the wipe test even when given germicidal radiation. The plates of Comparative Example 1, which do not include amine in the backbone of the polymer, were tacky regardless of formulation package or post exposure conditions.

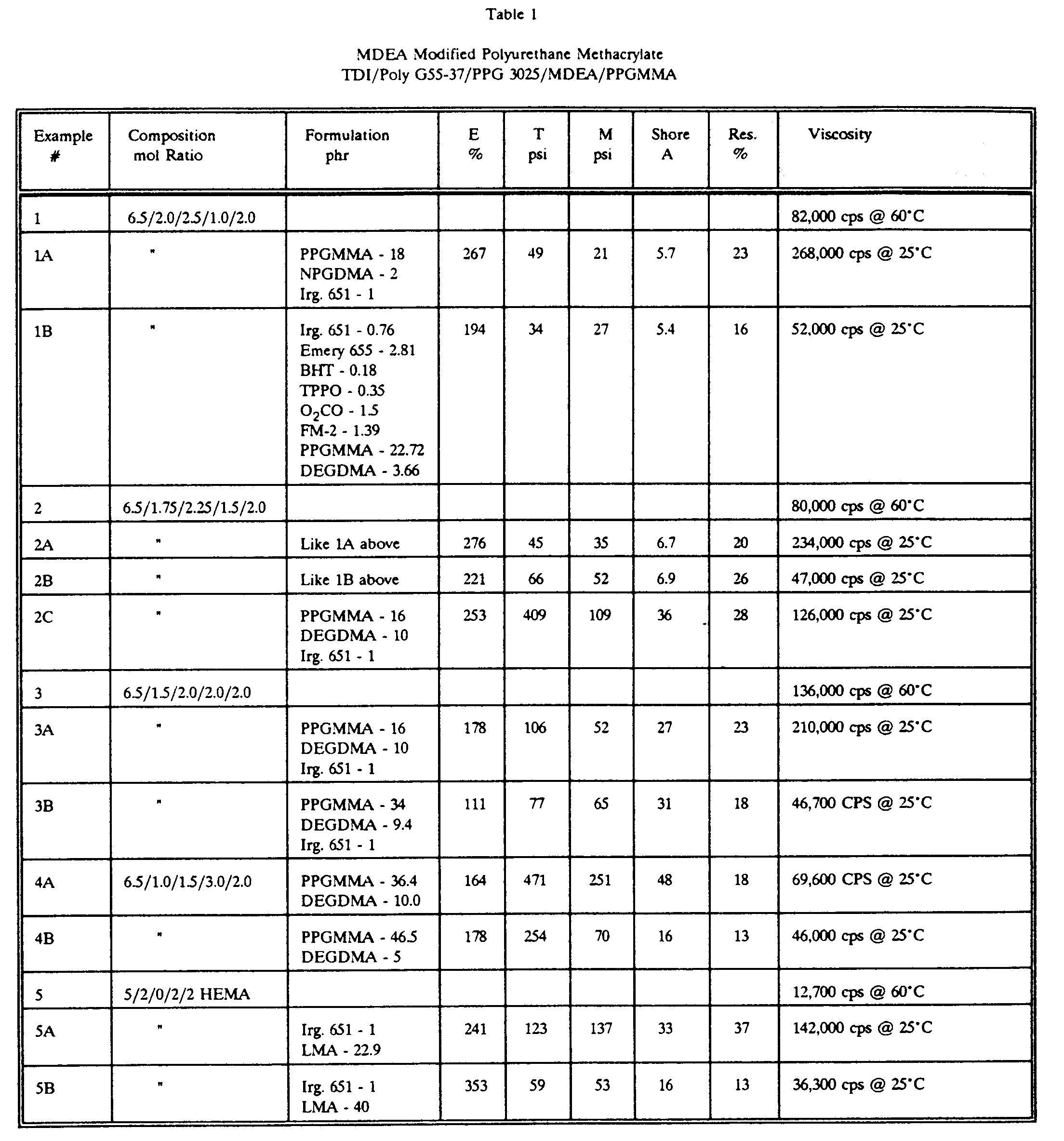

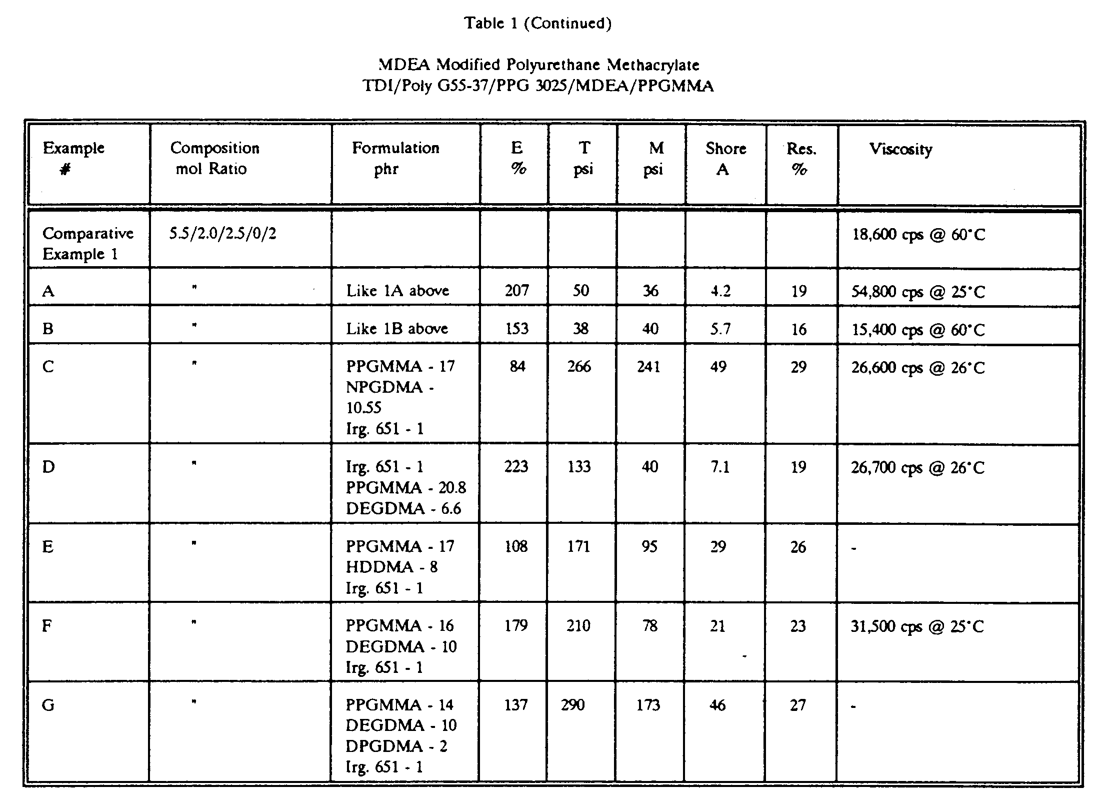

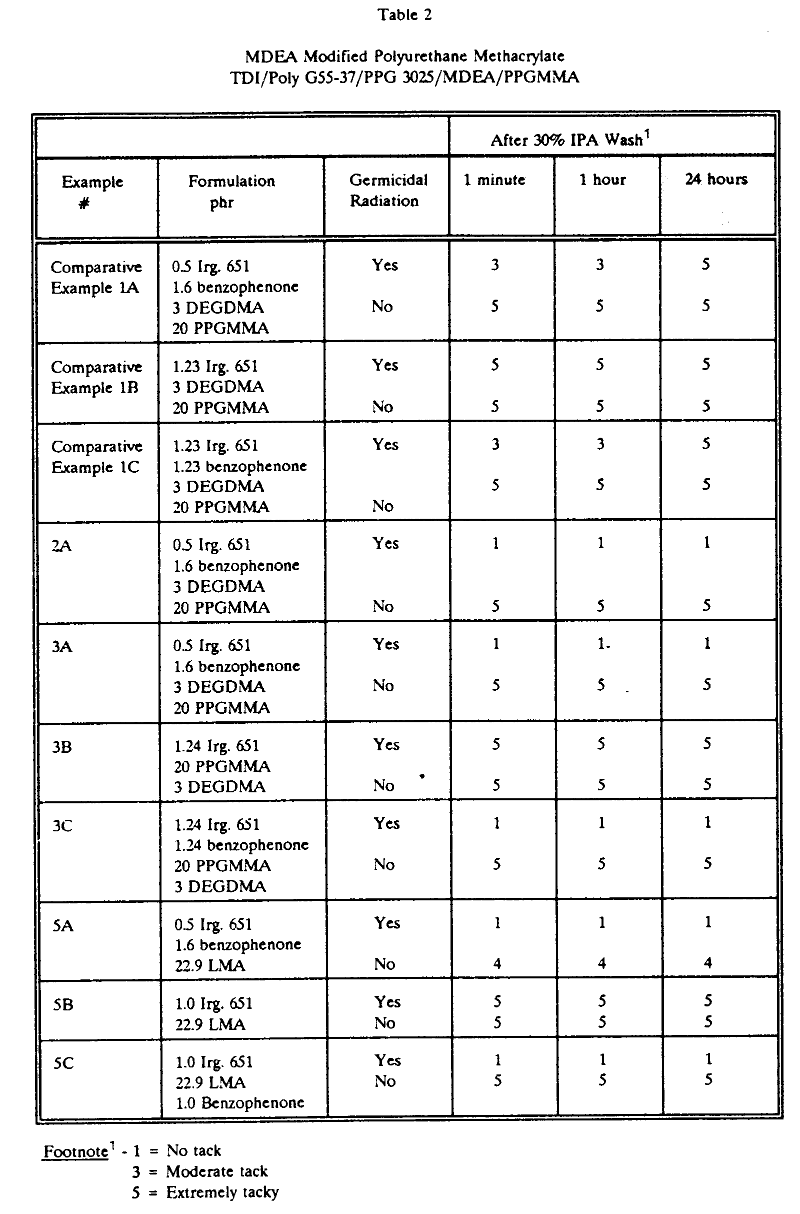

## Claims

1. A liquid photocurable polymer comprising J-YR¹-J, where the J's are identical and are
J is CH₂ = C(R)-C(:O)-O-R³-O-;
Y comprises B and R⁴;
B is -[X[(NHC(:0)]₂-O-(A-O)_{b}]ₓ-;
(A-O) is -CH₂CH₂-O, -CH₂CH(CH₃) -O-,
-CH₂CH₂CH₂CH₂-O-,
-CH₂CH₂CH(CH₃)-O-, or -CH₂CH(CH₃)CH₂-O- or mixtures thereof;
R⁴ is -[X(NH-C(:0)]₂-O-R⁵-R⁶-R⁷-O]_{y}-;
R¹ is -X[NH-C(:O)]₂-;
R is H or CH₃;
R³ is 1 to 7 carbon straight chain or branched alkylene or -(A-O)_{b}-;
R⁵ and R⁷ are the same or different alkylene groups with 1-8 carbons; or R⁵ can be
-(CH₂CH₂O)_{d}CH₂CH₂- provided R⁷ is
-(CH₂CH₂O)ₑCH₂CH₂-, where d and e are each 0 to 9 and d+e=3 to 15;
R⁶ is -N(R⁸) 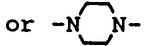 or -N(Ph), where Ph is phenyl;
R⁸ is H or alkyl group of 1 to 8 carbons; and
X is a divalent aliphatic, cycloaliphatic or an aromatic group containing 2 to 100 carbons, the or each b is independently selected from values such that the number average molecular weight of (AO)_{b} is in the range 600 to 8000, and x and z and the number of groups B and R⁴ are selected such that the molecular weight of Y-R¹ is at least 1,000 and of J-Y-R'-J is no more than 50,000.

2. The polymer according to claim 1 wherein B comprises
R¹⁰ and R¹¹ wherein
R¹⁰ is -[X[NHC(:O)]₂-O-(C₃H₆O)ₙ]- and
R¹¹ is -[X[NHC(:O)]₂-O-(C₂H₄O)ₘ-(C₃H₆O)ₚ-(C₂H₄O)ₘ]-.

3. The polymer according to claim 2 wherein
R is CH₃-;
R³ is -(CH₂CH(CH₃)O)_{q};
R⁵ and R⁷ are ethylene;
R⁶ is -N(R⁸);
R⁸ is CH₃; and
X is toluene.

4. The method of preparing the photocurable polymer of claim 1, the steps comprising:
(I) reacting, in the mole ratios stated, polyether diol having a molecular weight of from about 650 to 8000 (about 1 mole) with a diisocyanate, about 1.2 to about 4 moles, thereby end-capping the diols with isocyanate;
(II) adding a dialkanolamine in a mole ratio of from about 0.01 to about 5 to the reaction mixture of (I), thereby incorporating an amine into the backbone of the polymer; and
(III) adding to the reaction mixture of (II), an isocyanate reactive hydroxyalky(meth)acrylate from about 0.2 to about 1.0 moles and continuing the reaction to react the terminal isocyanate groups of (II) with the hydroxyl groups of the isocyanate reactive material thereby providing a photocurable polymer.

5. The method according to claim 4 wherein the mole ratio of the reactants, polyether diol: diisocyanate: dialkanolamine: hydroxyalky(meth)acrylate is about 1:1.4-2.6:0.2-1.2:0.4-0.8, the molar amount of the sum of the polyether diol and dialkanolamine preferably being less than the molar amount of diisocyanate.

6. The method according to claim 4 or claim 5 wherein the hydroxyalky(meth)acrylate is polypropylene glycol monomethacrylate.

7. The method according to any of claims 4 to 6 wherein the polyetherdiol is a mixture of polypropylene glycol diol and ethylene oxide-propylene oxide block polyether diol.

8. The method according to any of claims 4 to 7 wherein the diisocyanate is a mixture of 2,4-tolylene diisocyanate and 2,6-tolylene diisocyanate.

9. A method of preparing a flexographic printing plate surface substrate, the method comprising the steps of:
a) blending the photocurable polymer of claim 1 above with a photoactive(meth)acrylate monomer or oligomer in an amount that is about 0 weight % to about 70 weight % of the polymer and monomer blend;
b) blending the blend from step (a) with a photoinitiator system that comprises about 0.01 weight % to about 10 weight % of the total formulation of steps (a) and (b) of a benzophenone;
c) casting the blend from step (b) onto a cover sheet using a containment dam and laminating a backing sheet over the composition creating an article;
d) photocuring the casted liquid blend from step (c) through the backing sheet to create a plate floor of the plate and then curing through a negative to create an image with actinic radiation;
e) developing the image by washing away the uncured polymer that was unexposed in step (d) with aqueous surfactant solution;
f) drying the developed article; and
g) treating the cured surface substrate by exposing to germicidal radiation.

10. The method of claim 9 wherein the photoinitiator system comprises a first photoinitiator which is activated by radiation having wavelength greater than 300 nm and a second benzophenone photoinitiator which is not activated by radiation have wavelength greater than 300 nm but is activated by radiation having wavelength in the range 200 to 300 nm, preferably 2,2-dimethoxy-2-phenylacetophenone and benzophenone respectively.

11. The method according to claim 9 or claim 10 wherein step (b) further comprises the blending of additives selected from the group consisting essentially of antioxidants, antiozonants, ultra-violet radiation absorber, thermal polymerization inhibitors, stabilizers and mixtures thereof.

12. The method according to any of claims 9 to 11, further comprising placing the article into water and subjecting it to post-development exposure to actinic radiation to ensure through cure following step e).

13. The method according to claim 12, wherein the post-development exposure to actinic radiation and germicidal radiation occurs simultaneously in air or under water.

14. The method of any of claims 9 to 13 wherein the said actinic radiation has a wavelength of at least 300 nm.

15. Use of the product of the method of any of claims 9 to 14 as a printing plate.

16. A photocurable formulation comprising the polymer of any of claims 1 to 8 and a photoinitiator system comprising benzophenone.

17. A formulation according to claim 16 in which the photoactivator system comprises a first photoinitiator which is activated by radiation having wavelength greater than 300 nm and a second benzophenone photoinitiator which is not activated by radiation have wavelength greater than 300 nm but is activated by radiation having wavelength in the range 200 to 300 nm, preferably 2,2-dimethoxy--2-phenylacetophenone and benzophenone respectively.

18. A formulation according to claim 16 or 17 further comprising a photoactive monomer or oligomer, preferably a (meth)acrylate monomer, in an amount in the range 1 to 75%, preferably 5 to 50%, by weight based on the weight of the composition.

19. A formulation according to any of claims 16 to 18 cast on a backing sheet as a printing plate precursor.

20. An intermediate printing plate precursor which is the product of the method comprising the steps of:
a) blending the photocurable polymer of claim 1 above with a photoactive(meth)acrylate monomer or oligomer in an amount that is about 0 weight % to about 70 weight % of the polymer and monomer blend;
b) blending the blend from step (a) with a photoinitiator system that comprises about 0.01 weight % to about 10 weight % of the total formulation of steps (a) and (b) of a benzophenone;
c) casting the blend from step (b) onto a cover sheet using a containment dam and laminating a backing sheet over the composition creating an article;
d) photocuring the casted liquid blend from step (c) through the backing sheet to create a plate floor of the plate and then curing through a negative to create an image with actinic radiation;
e) developing the image by washing away the uncured polymer that was unexposed in step (d) with aqueous surfactant solution;
and which contains photocurable components and benzophenone photoinitiator such that it is further curable by exposure by germicidal radiation.
